Europäisches Patentamt

European Patent Office

Office européen des brevets

(19)

(11) Veröffentlichungsnummer: **0 499 659 A1**

## (12) EUROPÄISCHE PATENTANMELDUNG

(21) Anmeldenummer: **91102285.3**

(22) Anmeldetag: **18.02.91**

(51) Int. Cl.5: **H01S 3/25**, H01S 3/085

(43) Veröffentlichungstag der Anmeldung:
**26.08.92 Patentblatt 92/35**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Schraud, Gerhard, Dipl.-Ing.**
**Maximilianstrasse 13**
**W-8034 Germering(DE)**

(54) Oberflächenemittierende Halbleiterlaserarraystruktur mit vertikalem Resonator ohne Substrat.

(57) Oberflächenemittierende Halbleiterlaserarraystruktur aus GaAlAs- oder InGaAsP-Material ohne Substrat mit zueinander gekreuzten metallischen Kontaktierungsstreifen (l, o), die auf der n-bzw. p-Kontaktseite direkt unter bzw. über den Halbleiterbauelementen verlaufen. Die Einzelelemente befinden sich auf einer mit einer Oxidschicht (m) elektrisch isolierten metallischen Stützschicht (i) die gleichzeitig als Wärmesenke dient. Beide Halbleiterreflektoren können mit metallischen oder dielektrischen Zusatzschichten ergänzt werden. Die Gesamtstruktur ist quasi-monolithisch mit anderen Halbleitern integrierbar.

FIG 2

EP 0 499 659 A1

Die vorliegende Erfindung betrifft eine elektrisch gepumpte Halbleiterlaserarraystruktur ohne Substrat mit zueinander gekreuzten Leiterbahnen und einzeln selektierbaren Elementen gemäß dem Oberbegriff des Anspruches 1.

Für künftige Anwendungen in der optischen Kommunikationstechnik und optischen Signalverarbeitung können oberflächenemittierende Laserdioden mit vertikalem Resonator zur Erzeugung und Verarbeitung optischer Signale sehr vorteilhaft eingesetzt werden, da sie sich zu zweidimensionalen Arraystrukturen integrieren lassen. Diese Strukturen sollen eine hohe Packungsdichte aufweisen und gleichzeitig über viele parallele Datenkanäle große Informationsmengen mit hoher Geschwindigkeit verarbeiten. Dabei müssen die Einzelelemente über Leiterbahnen einzeln adressierbar sein. Zusätzlich muß bei eng beieinanderliegenden Laserdioden für eine wirksame Ableitung der auftretenden Verlustwärme gesorgt werden.

Insbesondere in den letzten beiden Jahren wurden zahlreiche unteschiedliche Einzellaserstrukturen realisiert, die zum Teil sehr gute Leistungsmerkmale aufweisen und auch laterale Resonatorabmessungen von wenigen $\mu$m besitzen. Die Resonatorspiegel werden üblicherweise als $\lambda/4$ Schichtenstapel im Epitaxiewachstumsprozeß (zumeist MBE oder MOVPE) aus Halbleitermaterial aufgewachsen. Zur Verbesserung der Spiegeleigenschaften kann der Spiegel auf der Epitaxieseite nach dem Wachstum mit metallischen oder dielektrischen Zusatzschichten kombiniert werden. Die günstigste Ableitung der auftretenden Verlustwärme erfolgt durch das Aufbringen der Bauelemente mit ihrer Epitaxieseite auf geeignete Wärmesenken. In diesem Fall muß das im Laser erzeugte Licht entweder durch ein für die Strahlung transparentes Substrat oder durch in das Substrat geätzte Krater emittiert werden. Seit 1989 werden zweidimensionale Laserarrays mit hoher Packungsdichte hergestellt, die jedoch keine Kontaktierung über Leiterbahnen beinhalten, so daß die einzelnen Dioden über Kontaktspitzen selektiert werden, oder alle Elemente über eine Elektrode gemeinsam kontaktiert sind. Zur Adressierung einzelner Dioden in einer Arrayanordnung über Leiterbahnen muß sowohl die n- als auch die p-Seite einer einzelnen Laserdiode für eine elektrische Kontaktierung unmittelbar zugänglich sien, was bei Lasern mit Substrat nur von der Epitaxieseite her mit relativ hohem Platzbedarf möglich ist und eine effektive Wärmeableitung mit Hilfe einer Wärmesenke auf der Epitaxieseite erschwert.

Oberflächenemittierende Laserdiode und Arrays sind in den folgenden Veröffentlichungen beschrieben:

Ibaraki, A.; Kawashima, K.; Furusawa, K.; Ishirawa, T.;Yamaguchi, T.; Niina, T.; "Buried heterostructure GaAs/GaAlAs distributed Bragg reflector surface emitting laser with very low threshold (5.2 mA) under room temperature CW conditions", Jap. J. Appl. Phys. 28, L667 - L 669, (1989); Lee, Y. H.; Jewell, J. L.; Scherer, A.; McCall, S. L.; Harbison, J.R.; Florez, L. T.: "Room-temperature continuous-wave vertical-cavity single-quantum-well microlaser diodes." Electron. Lett. 25, 1377 - 1378, (1989); Tai, K.; Fischer, R.J.; Seabury, C. W.; Olsson, N.A.; Huo, T. D.; Ota, Y.; Cho, A.Y.; "Room temperature continuous-wave vertical-cavity surface-emitting GaAs injection lasers." Appl. Rhys. Lett. 55, 2473 - 2475, (1989); Hasnain, G.; Tai, K.; Wynn, J.D.; Wang, Y.H.; Fischer, R. J.; Hong, M.; Weir, B.E.; Zydzik, G. J.; Mannaerts, J. P.; Gamelin, J.; Cho, A.Y.: "Continuous wave top surface emitting quantum well lasers using hybrid metal/semiconductor reflectors." Electron. Lett. 26, 1590 - 1592, (1990); Wang, Y.H.; Tai, K.; Wynn, J.D.; Hong, M.; Fischer, R.J.; Mannaerts, J.R.; Cho, A.Y.: "GaAs/AlGaAs multiple quantum well GRIN-SCH vertical cavity surface emitting laser diodes." IEEE Photon. Techn. Lett. 2, 456-458, (1990); Deppe, D.G.; van der Ziel, J. P.; Chand, N.; Zydzik, G.J.; Chu, N.G.: "Phase-coupled two-dimensional AlGaAs-GaAs vertical-cavity surface-emitting laser array." Appl. Phys. Lett. 56, 2089 - 2091 (1990); Yoo, H.-J.; Scherer, A.; Harbison, J. R.; Florez, L.T.; Paek, E. G.; Van der Gaag, B. P.; Hayes, J. R.; Von Lehmen, A.; Kapon, E.; Kwon, Y.-S.: "Fabrication of a two-dimensional phased array of vertical-cavity surface-emitting laser." Appl. Phys. Lett. 56, 1198 - 1200 (1990); Uchiyama, S.; Iga, K.: "Two-dimensional array of GaInAsP/InP surface-emitting lasers." Electron. Lett. 21, 162 - 164 (1985); Rollentier, L.; Demeester, P.; Ackaert, A.; Buydens, L.; Van Daele, P.; Baets, R.: "Epitaxial lift-off GaAs LEDs to Si for fabrication of optoelectronic integrated circuits." Electron. Lett. 26, 193 - 194 (1990); Yablonovitch, E.; Kapon, E.; Gmitter, T.J.; Yun, C.R.; Bhat, R.: "Double heterostructure GaAs/AlGaAs thin film diode lasers on glass substrates." IEEE Rhoton. Techn. Lett. 1, 41 - 43 (1989);

Aufgabe der vorliegenden Erfindung ist es, eine elektrisch gepumpte Halbleiterlaserarraystruktur anzugeben, bei der es möglich ist, die jeweiligen Elemente einzeln zu selektieren, wobei gleichzeitig ein geringer Platzbedarf bei minimalem Adressierungsaufwand gegeben ist.

Diese Aufgabe wird mit der Struktur des Anspruches 1 gelöst. Weitere Ausgestaltungen ergeben sich aus den Unteransprüchen.

Mit Hilfe der nachfolgend dargestellten Halbleiterlaserarraystruktur ohne Substrat ist es möglich, die jeweiligen Elemente des Arrays über gekreuzte Leiterbahnen einzeln elektrisch zu selektieren, wobei gleichzeitig ein geringer Platzbedarf bei minimalem Adressierungsaufwand gegeben ist. In einer solchen Struktur können beide Halbleiterspiegel einer Laserdiode gleichzeitig mit einem Metall oder mit transparenten dielektrischen λ/4 Schichten und den damit verbundenen Vorteilen kombiniert werden. Zusätzlich ist eine gute Verlustwärmeableitung gegeben.

Es folgt die Beschreibung einer erfindungsgemäßen Arraystruktur anhand der Figuren 1 bis 3.

Fig. 1    zeigt eine Einzelhalbleiterlaserstruktur mit vertikalem Resonator ohne Substrat.

Fig. 2    zeigt eine Halbleiterlaserarraystruktur ohne Substrat, die aus Einzelelementen gemäß Fig. 1 zusammengesetzt ist.

Fig. 3    zeigt ein mögliches Beispiel, wie eine Arraystruktur gemäß Fig. 2 mit anderen Halbleiterchips quasi-monolithisch integriert werden kann.

Ausgehend von der technologischen Herstellung eines Einzelelementes wird die Arraystruktur im folgenden näher beschrieben. Dabei wird beispielhaft das GaAs/GaAlAs-Materialsystem auf GaAs-Substrat gewählt.

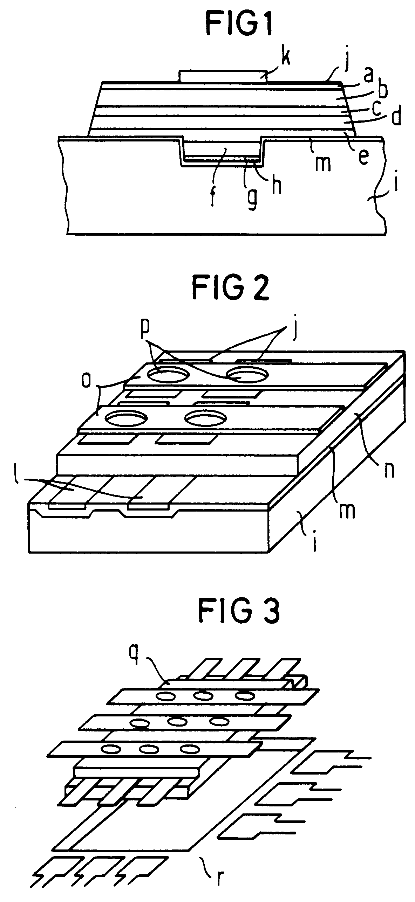

Die Herstellung von erfindungsgemäßen Einzelelementen entsprechend Fig. 1 gestaltet sich wie folgt:

Auf einem n-dotierten GaAs-Substrat werden die Halbleiterschichten bestehend aus $n^+$-GaAs-Kontaktschicht (a), n-GaAlAs/AlAs-Braggreflektor (b), n-GaAlAs-Mantelschicht (c), aktiver Zone (d) aus GaAs, p-GaAlAs-Mantelschicht (e), p-GaAlAs/AlAs-Braggreflektor(f) und $p^+$-GaAs-Kontaktschicht (g) epitaktisch mit MBE (Molekularstrahlepitaxie) aufgewachsen. Nach dem Aufdampfen eines hochreflektiven Ag/Au-Kontaktes (h) im Ultrahochvakuum der MBE-Anlage erfolgt die Strukturierung der p-Seite mit fotolithografischen und naßchemischen Verfahren. Daran anschließend wird eine dünne metallische Stützschicht aus Gold (i), die gleichzeitig als Wärmesenke dient, galvanisch aufgewachsen. Das n-GaAs-Substrat wird entfernt, n-Ringkontakte (j) werden auf der freigelegten $n^+$-Kontaktschicht (a) aufgedampft, und die Einzelelemente durch naßchemisches Ätzen abgetrennt. Statt der naßchemischen Ätzung kann auch alternativ reaktives Ionenätzen oder Protonenisolation zur Bauelementstrukturierung eingesetzt werden. Auf dem freigelegten Fenster in der n-Metallisierung kann entweder eine semitransparente Silberschicht aufgedampft werden oder ein aus λ/4-Schichten bestehender Schichtenstapel aus dielektrischen Schichten (k) (beispielsweise $SiO_2/Si_3N_4$). Die dielektrischen Schichten können bei der in Fig. 2 gezeigten Arraystruktur ganzflächig aufgebracht werden.

Die Herstellung von Strukturen im InGaAsP/InP-Materialsystem kann nach dem gleichen Prinzip mit folgenden Halbleiterschichten erfolgen: $n^+$-InGaAsP-Kontaktschicht (a), n-InGaAsP/InP-Braggreflektor (b), n-InP-Mantelschicht (c), aktive Zone (d) aus InGaAsP, p-InP-Mantelschicht (e), p-InGaAsP/InP Braggreflektor (f) und $p^+$-InGaAsP-Kontaktschicht (g).

Aus der Literatur bekannte GRINSCH-Mehrfach-PotentialtopfStrukturen oder periodische Gewinnstrukturen (PGS) für die aktive Zone können mit der erfindungsgemäßen substratlosen Struktur alternativ realisiert werden.

Die Struktur nach Fig. 1 bietet gegenüber oberflächenemittierenden Lasern mit GaAs-Substrat insbesondere folgende Vorteile:

Durch das Entfernen des Substrates können die lateralen Abmessungen im Vergleich zu Lasern, die Licht auf der Substratseite emittieren, bedeutend reduziert werden, da eine Ätzung eines Kraters mit geneigten Ätzflanken im Substrat entfallen kann.

Durch die an die p-Mantelschicht (e) und an den p-Reflektor (f) angrenzende metallische Stützschicht wird eine gute Wärmeabfuhr erreicht.

Bei Verwendung von kombinierten Halbleiter/Metall-Reflektoren auf der p-Reflektorseite kann ein hoher Reflexionsfaktor bei minimaler Schichtenanzahl für den Braggspiegel erzielt werden. Dies hat reduzierte Halbleiterabsorptionsverluste, verminderten Serienwiderstand und kürzere MBE-Wachstumszeiten zur Folge. Zusätzlich können auf der n-Reflektorseite durch das Aufbringen von transparenten dielektrischen Braggreflektoren oder einer semitransparenten Metallschicht die Anzahl der Halbleiterspiegelschichten ebenfalls reduziert und die erwähnten Vorteile ausgenutzt werden.

Eine Erweiterung des erfindungsgemäßen Aufbaues zum zweidimensionalen Laserarray gemäß Fig. 2 gestaltet sich wie folgt:

Bei der Herstellung zweidimensionaler Laserarrays werden auf der p-Kontaktseite vor dem Aufwachsen der metallischen Stützschicht (i) p-Kontaktierungsstreifen (1) und eine isolierende Oxidschicht (m) aufgebracht. Die Kontaktierungsstreifen bilden mit den $p^+$-dotierten GaAs-Kontaktschichten (h) ohmsche Kontakte, mit den Mantelschichten (e) einen sperrenden Schottky-Kontakt. Auf der n-Kontaktseite werden nach dem Aufbringen einer einebnenden Polyamidschicht (n) zusätzliche n-Kontaktierungsstreifen (o) aufgedampft, die gekreuzt, insbesondere im rechten Winkel, zu den p-Leiterbahnen (1) verlaufen und über den in das Polyamid eingebetteten Laserstrukturen aus Halbleitermaterial entsprechend Fig. 1 Fensteröffnungen (p) für die austretende Laserstrahlung besitzen.

In einem zweidimensionalen Laserarray sind Einzelelemente, die durch ein Substrat miteinander verbunden sind, nur mit relativ hohem Kontaktierungsaufwand bei gleichzeitig höherem Flächenbedarf von einer Seite her selektierbar. Bei der erfindungsgemäßen wie vorstehend beschriebenen Struktur werden dagegen zuerst die p- und dann die n-Kontaktseite eines Einzelelementes strukturiert. Durch das Aufbringen von zueinander gekreuzten n- und p-Kontaktierungsstreifen können zweidimensionale Lasermatrizen mit einzeln selektierbaren Elementen hergestellt werden. Verdrahtungs- und Adressierungsaufwand sind dabei minimal. Alle bei der Herstellung erforderlichen Photoprozesse werden auf planaren Oberflächen durchgeführt.

In Fig. 3 ist eine quasi-monolithische Integration der Arraystruktur aus Fig. 2 mit weiteren Bauelementen dargestellt. Dabei können die Laserdioden einzeln oder als Arrays (q) auf beliebigen, mit elektrischen Schaltkreisen versehenen Substraten (r) aufgebracht sein (quasi-monolithische optoelektronische Integration). Eine justierte und induktivitätsarme Kontaktierung, beispielsweise durch Thermokompression, ist aufgrund der flachen Bauelemente möglich. Dadurch gelingt es z. B., Laserarrays als Sendeelemente in GaAs-Technologie mit elektronischen Treiberstufen und elektronischer Adressierlogik in Si-Technologie zu kombinieren.

**Patentansprüche**

1. Oberflächenemittierende Halbleiterlaserarraystruktur ohne Substrat mit vertikalem Resonator und elektrisch isolierter, metallischer Stützschicht (i), bei der durch die unmittelbare Strukturierung der n- und p-Seite der Einzeldioden (j) und durch die Verwendung von zueinander gekreuzt verlaufenden Leiterbahnen (l, o) unter den n- und über den p-Seiten der Einzeldioden diese einzeln über je zwei Leiterbahnen auf elektrischem Wege adressiert werden können.

2. Halbleiterlaserarraystruktur nach Anspruch 1, die aus Einzeldioden zusammengesetzt ist, bei denen die Reflektoren auf der n- und p-Seite aus kombinierten Metall-/Halbleiterspiegeln (f, g, h) und/oder kombinierten dielektrischen Halbleiterspiegeln (b, a, k) aufgebaut sind.

3. Halbleiterlaserarraystruktur nach Anspruch 1 oder 2, bei der eine mit einer elektrisch isolierenden Oxidschicht (m) versehene metallische Stützschicht (i) als Wärmesenke dient.

4. Halbleiterlaserarraystruktur nach einem der Ansprüche 1 bis 3, bei der die zueinander gekreuzt verlaufenden Leiterbahnen (l, o) jeweils unter bzw. über den Einzeldioden verlaufen und keinen zusätzlichen Platz in seitlicher Richtung beanspruchen.

5. Halbleiterlaserarraystruktur nach einem der Ansprüche 1 bis 4, bei der das Halbleitermaterial aus dem System GaAs/GaAlAs ist.

6. Halbleiterlaserarraystruktur nach einem der Ansprüche 1 bis 4, bei der das Halbleitermaterial aus dem System InP/InGaAsP ist.

7. Halbleiterlaserarraystruktur nach einem der Ansprüche 1 bis 6, die mit anderen Bauelementen quasi-monolithisch integriert ist.

8. Oberflächenemittierender Halbleiterlaser mit in der Richtung der Emission der Strahlung aufeinanderfolgenden Schichten (a, b, c, d, e, f, g) aus Halbleitermaterial und mit einem in diesen Schichten ausgebildeten in der Richtung der Emission der Strahlung ausgerichteten Resonator, bei dem die Schichten (a, b, c, d, e, f, g) aus Halbleitermaterial auf einer Stützschicht (i) angeordnet sind, bei dem zwischen dieser Stützschicht (i) und der dazu nächstliegenden Schicht (g) aus Halbleitermaterial ein erster Kontakt (h) für Strominjektion in einen für Strahlungserzeugung vorgesehenen Bereich vorhanden ist, bei dem auf der diesem ersten Kontakt (h) gegenüberliegenden Seite der Schichten (a, b, c, d, e, f, g) aus Halbleitermaterial ein zweiter Kontakt (j) vorhanden ist und bei dem dieser zweite Kontakt (j) einen für die Emission der Strahlung vorgesehenen Bereich freiläßt.

9. Halbleiterlaser nach Anspruch 8, bei dem die Stützschicht (i) Metall ist und bei dem die Schichten (a, b, c, d, e, f, g) aus Halbleitermaterial auf einer mit einer Isolationsschicht (m) versehenen Oberfläche der Stützschicht (i) angeordnet sind.

10. Halbleiterlaser nach Anspruch 8 oder 9, bei dem die Schichten aus Halbleitermaterial eine aktive Schicht (d) zwischen zwei Mantelschichten (c, e) zwischen zwei Reflektorschichten (b, f) zwischen zwei Kontaktschichten (a, g) umfassen und bei dem jeder Kontakt (h, j) auf einer jeweiligen dieser Kontaktschichten (a, g) angeordnet ist.

11. Halbleiterlaser nach Anspruch 10, bei dem die Kontaktschichten (a, g) InGaAsP, die Reflektorschichten (b, f) InGaAsP/InP-Bragg-Reflektorschichten, die aktive Schicht (d) InGaAsP und die Mantelschichten (c, e) InP sind.

12. Halbleiterlaser nach Anspruch 10 oder 11, bei dem die zwischen dem ersten Kontakt (h) und der aktiven Schicht (d) angeordneten Schichten (e, f, g) jeweils für p-Leitung dotiert sind und bei dem die zwischen den zweiten Kontakt (j) und der aktiven Schicht (d) angeordneten Schichten (a, b, c) jeweils für n-Leitung dotiert sind.

13. Halbleiterlaser nach einem der Ansprüche 8 bis 12, bei dem auf dem für die Emission der Strahlung von dem zweiten Kontakt (j) freigelassenen Bereich eine semitransparente Goldschicht (k) vorhanden ist.

14. Halbleiterlaser nach einem der Ansprüche 8 bis 12, bei dem auf dem für die Emission der Strahlung von dem zweiten Kontakt (j) freigelassenen Bereich eine mehrlagige Schicht (k) aus dielektrischen λ/4-Schichten vorhanden ist.

15. Halbleiterlaser nach einem der Ansprüche 8 bis 14, bei dem das Halbleitermaterial aus dem System GaAs/GaAlAs ist.

16. Halbleiterlaser nach einem der Ansprüche 8 bis 14, bei dem das Halbleitermaterial aus dem System InP/InGaAsP ist.

17. Array von Halbleiterlasern nach einem der Ansprüche 8 bis 16, bei dem Leiterbahnen (l, o) vorhanden sind, die jeweils mehrere erste Kontakte der Halbleiterlaser und jeweils mehrere zweite Kontakte der Halbleiterlaser verbinden.

18. Array nach Anspruch 17, bei dem die Halbleiterlaser in einer einebnenden Passivierungsschicht (n) angeordnet sind.

19. Array nach Anspruch 18, bei dem die Passivierungsschicht (n) Polyamid ist.

20. Array nach einem der Ansprüche 17 bis 19 mit einer den Halbleiterlasern gemeinsamen Stützschicht (i), bei dem die Leiterbahnen (l, o) so angeordnet sind, daß jedes Paar einer Leiterbahn (l), die jeweils erste Kontakte (h) der Halbleiterlaser miteinander verbindet, und einer Leiterbahn (o), die jeweils zweite Kontakt (j) der Halbleiterlaser miteinander verbindet, höchstens einen Halbleiterlaser gemeinsam kontaktiert.

21. Array nach einem der Ansprüche 17 bis 20, bei dem die Resonatoren durch Reflektoren, die entweder aus einer Halbleiter-Metall-Schichtfolge oder aus einer Halbleiter-Dielektrikum-Schichtfolge bestehen, begrenzt werden.

22. Array nach einem der Ansprüche 17 bis 21, bei dem die Stützschicht (i) Metall ist und als Wärmesenke dient.

23. Array nach einem der Ansprüche 17 bis 22, bei dem die Breite der Leiterbahnen (l, o) jeweils die seitliche Abmessung der Halbleiterlaser nicht übertrifft.

24. Array nach einem der Ansprüche 17 bis 23 in quasi-monolithischer Integration mit weiteren Anordnungen von Halbleiterbauelementen.

EP 0 499 659 A1

## FIG 1

## FIG 2

## FIG 3

Europäisches
Patentamt

**EUROPÄISCHER RECHERCHENBERICHT**

Nummer der Anmeldung

EP 91 10 2285

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PROCEEDINGS OF THE 16TH EUROPEAN CONFERENCE ON OPTICAL COMMUNICATION (ECOC'90), Amsterdam , 16.- 20. September 1990, Band 2, Seiten 896-931; K. IGA: "Surface operating electrooptic devices and their application to array parallel signal processing" * Kapitel 1,2; Figuren auf den Seiten: 903-906,910-912,914,916,919,931 * --- | 1,2,5-8 ,10-11, 13-17, 21,24 | H 01 S 3/25 H 01 S 3/085 |
| A | PATENT ABSTRACTS OF JAPAN, Band 14, Nr. 557 (E-1011), 11. Dezember 1990; & JP-A-02 240 991 (HITACHI LTD) 25-09-1990 * Ganze Zusammenfassung * --- | 1,2,6,8 ,10,16, 17,21 | |
| A | ELECTRONICS LETTERS, Band 25, Nr. 21, Oktober 1989, Seiten 1427-1428, Stevenage, Herts, GB; J.C. HO et al.: "Novel hemispherical vertical cavity 1.3 mum surface-emitting laser on semi-insulating substrate" * Ganzer Artikel * --- | 8,13 | RECHERCHIERTE SACHGEBIETE (Int. Cl.5) H 01 S |
| A | US-A-4 309 670 (R.D. BURNHAM et al.) * Spalte 8, Zeilen 6-65; Spalte 13, Zeilen 17-64; Spalte 15, Zeile 8 - Spalte 16, Zeile 17; Figuren 6B,7,19,22,23 * ----- | 8,10,15 | |

Der vorliegende Recherchenbericht wurde für alle Patentansprüche erstellt

| Recherchenort | Abschlußdatum der Recherche | Prüfer |
|---|---|---|
| DEN HAAG | 07-10-1991 | GNUGESSER H.M. |